# EUROPEAN PATENT APPLICATION

(11) **EP 4 385 652 A1**
(43) Date of publication of application: **19.06.2024**
(21) Application number: 23816350.5
(22) Date of filing: 31.05.2023
(51) Int. Cl.: B23K 26/21, B23K 37/04, H01M 50/516, H01M 50/519, B23K 101/42

(54) **LASER WELDING DEVICE AND WELDING METHOD USING SAME**

(30) Priority: 31.05.2022 KR 20220066902; 31.05.2022 KR 20220066903; 30.05.2023 KR 20230069515
(71) Applicant: LG Energy Solution, Ltd., Seoul 07335 (KR)
(72) Inventor: JANG, Jae Young, Daejeon 34122 (KR); LEE, Jin Hyun, Daejeon 34122 (KR); HWANG, Jo Yeon, Daejeon 34122 (KR); KWON, Jae Kuk, Daejeon 34122 (KR); JUNG, Dae Ho, Daejeon 34122 (KR)
(74) Representative: Goddar, Heinz J.
(86) International application number: PCT/KR2023/007417
(87) International publication number: WO 2023/234689

(57) **Abstract**

The present invention relates to a laser welding apparatus including a lower jig, a laser welding unit configured to weld a metal and another metal to each other, the metal being disposed at an upper surface of a PCB disposed on the lower jig, and an upper jig configured to support at least one of at least a part of the upper surface of the PCB, at least a part of an upper surface of the metal, and at least a part of an upper surface of the another metal, wherein the upper jig is fixed such that the vertical position of the upper jig is constant, or when the upper jig is moved upwards and downwards, the upper jig is configured to be fixed at a specific position, and a welding method using the same. A laser welding apparatus capable of performing welding while vibrating a PCB and a welding method using the same are also disclosed.

## Description

### [Technical Field]

The present invention relates to a laser welding apparatus and a welding method using the same. More particularly, the present invention relates to a laser welding apparatus capable of reducing or inhibiting weak welds which may occur due to focal position deviation during laser welding between metals each having a small thickness and a welding method using the same.

### [Background Art]

Electric vehicles use a battery module in which a plurality of battery cells are electrically connected to each other or a battery pack in which a plurality of battery modules is coupled to each other. A plurality of battery cells received in a battery module or a battery pack are connected to each other in series and/or in parallel. The battery cells are directly welded to a busbar, or electrode leads are welded to a printed circuit board (PCB).

Welding includes electric resistance welding, ultrasonic welding, and laser welding, and use of the laser welding is increasing due to an ability to precisely weld small regions, high working speed, and low thermal deformation.

Conventionally, in order to weld an electrode lead to the PCB, a metal pad having a thickness of 0.3 mm is added to PCB copper foil, and the electrode lead is welded to the metal pad. After the PCB copper foil and the metal pad are electrically connected to each other, the electrode lead is disposed on the metal pad. After the vertical position of a laser welding apparatus is adjusted to focus, the metal pad and the electrode lead are welded to each other. Even though the focus of the laser welding apparatus is not accurately positioned between the metal pad and the electrode lead, the metal pad is melted and electrically coupled to the electrode lead after a certain period of time due to the thickness of the metal pad.

In recent years, various attempts have been made to reduce an internal space of the battery module or the battery pack in order to increase the capacity of the battery module or the battery pack. When one metal pad is provided, the thickness thereof is not a big problem, but when a multilayered PCB is used, it is necessary to reduce the thickness thereof.

When the PCB copper foil and the electrode lead are welded to each other without the metal pad, the focus of the laser welding apparatus must be very accurately positioned. In general, the thickness of each of the PCB copper foil and the electrode lead is 0.1 mm or less, and if the focus of the laser welding apparatus is not accurately positioned therebetween, there occurs a problem such as no welding, melting of only a part of the surface of the electrode lead, or damage to the PCB copper foil. The vertical height of the laser welding apparatus is adjusted to focus, and then the laser welding apparatus performs overall welding while moving horizontally in a longitudinal direction or a thickness direction of the electrode lead. The focal position may fluctuate due to mechanical deviation which may occur during the horizontal movement of the laser welding apparatus, whereby accuracy of welding position may be lowered, and therefore weak welds may occur. Even though the laser welding apparatus moves horizontally at the same height without deviation, weak welds may occur due to deviation in the thickness of a PCB substrate, the copper foil, and the electrode lead.

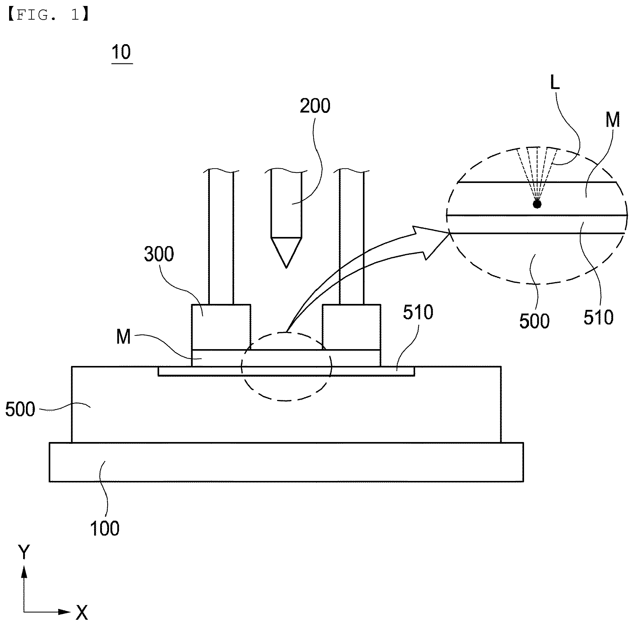

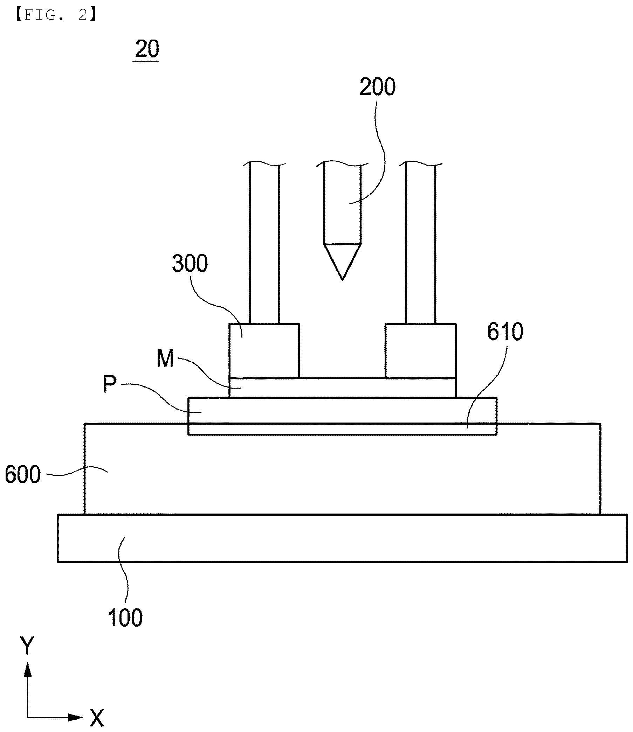

FIG. 1 is a sectional schematic view of a conventional laser welding apparatus 10. The laser welding apparatus 10 of FIG. 1 does not use a metal pad P, unlike FIG. 2. Referring to FIG. 1, the conventional laser welding apparatus 10 includes a lower jig 100 configured to support a PCB 500, a laser welding unit 200 configured to weld a metal 510 disposed in an upper surface of the PCB 500 by insertion and another metal M located at an upper surface of the metal 510 to each other, and an upper jig 300 configured to press a part of the upper surface of the PCB 500.

Here, the metal 510 may generally be copper foil of the PCB, and the another metal M may be an electrode lead.

The conventional laser welding apparatus 10 welds the metal 510 and the another metal M to each other using a laser L such that the metals are electrically connected to each other.

Referring to a right enlarged view of FIG. 1, the laser focus may easily deviate from the interface due to the small thickness of each of the metal 510 and the another metal M. High precision is required to position the focus on the interface between the thin metals. As a result, weak welds may occur between the metal 510 and the another metal M.

FIG. 2 is a sectional schematic view of another conventional laser welding apparatus 20. FIG. 2 shows the case in which the laser welding apparatus 20 uses a separate metal pad P. Referring to FIG. 2, conventional laser welding apparatus 20 includes a lower jig 100 configured to support a PCB 600, a laser welding unit 200 configured to weld a metal 610 mounted in an upper surface of the PCB 600 and a metal pad P and another metal M located at an upper surface of the metal 610 to each other, and an upper jig 300 configured to press a part of an upper surface of each thereof.

Here, the metal 610 may generally be copper foil of the PCB, the metal pad P may be a separate copper foil to assist welding, and the another metal M may be an electrode lead.

In both FIGS. 1 and 2, the vertical position of the lower jig 100 is fixed.

The conventional laser welding apparatus 20 must initially weld the metal 610 and the another metal M using a laser L such that the metals are electrically connected to each other. Welding focus may be changed or there is difficulty in accurately positioning the welding focus due to the small thickness of each of the metal 610 and the another metal M. As a result, there is a problem in that weak welds may occur between the metal 610 and the another metal M.

In order to solve the problem, the metal pad P is added between the metal 610 and the another metal M to prevent the occurrence of weak welds. The metal pad P, which serves as an intermediate medium, electrically connects the metal 610 and the another metal M to each other. In this case, the manufacturing cost increases, and application to technology to achieve high capacity or weight reduction is impossible due to an increase in thickness caused by welding.

In order to achieve high capacity or weight reduction, the use of the conventional laser welding apparatus 20 is not an adequate solution, and the problem of welding defects must be solved while using the conventional laser welding apparatus 10.

In one practical application of FIG. 1, for example, the metal 510 is copper foil and has a thickness of 0.08 mm. The deviation due to the thickness of the PCB 500 is +-0.15 mm, and the tolerance due to the location of the laser welding unit 200 is +-0.2 mm. When the deviation due to the thickness of the PCB 500 and the tolerance due to the position of the laser welding unit 200 are accumulated, the focus deviation of the laser welding unit 200 becomes +-0.35 mm, which exceeds the thickness of the copper foil 510. In this case, the focus of the laser welding unit 200 is not aligned with the interface between the copper foil 510 and the another metal M, resulting in welding defects.

According to another conventional solution, laser welding may be performed in order to achieve "overwelds" rather than "weak welds". This means that overwelding is performed such that a region or thickness to be welded is greater than a normal level. In this case, the copper foil 510 and the another metal M may be welded to each other, but an underlying layer of the PCB 500 may be damaged by overwelding.

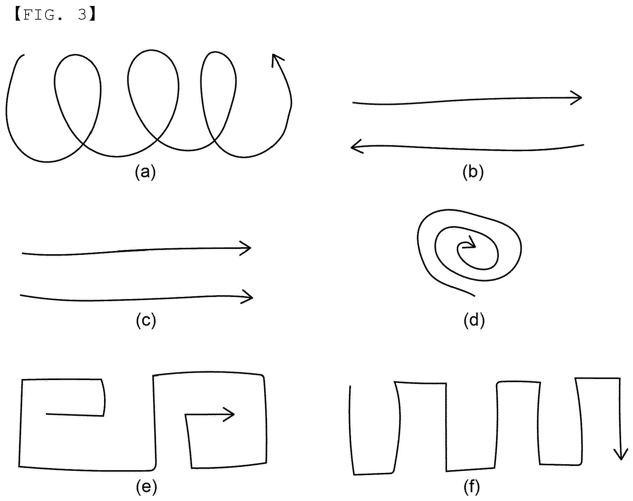

FIG. 3 shows examples of a pattern resulting from laser welding. The figure shows shapes in which the laser welding unit 200 is moved while performing welding. Even though normal welding is performed without overwelding, overwelding may occur at overlapping parts of the weld when welding is performed in the shape shown in (a) of FIG. 3. In order to solve the problem of "overwelding" described above and the problem of overwelding due to pattern overlapping as shown in (a) in FIG. 3, the applicant of the present invention has derived a method of providing a separate metal protective layer in the middle of a PCB composed of multiple layers, and has applied for such a configuration. In this case, however, there is a problem in that a separate PCB including a metal protective layer must be prepared.

Patent Document 1 discloses a laser welding jig configured to weld a PCB and a connecting member to each other in tight contact with each other. Patent Document 1 is intended to prevent the occurrence of welding defects as the result of the PCB and the connecting member being spaced apart from each other. Patent Document 1, which is technology to simply press the PCB and the connecting member such that the PCB and the connecting member are in tight contact with each other, does not take into account the position of each of the PCB and the connecting member, and thus does not disclose a solution capable of solving the focus deviation of laser welding caused by the small thickness of each of the objects to be welded.

Patent Document 2 discloses a laser welding apparatus for electrode terminals of a coin cell including an ultrasonic vibration control unit that vibrates in a leftward-rightward direction.

Patent Document 2 adds ultrasonic vibration, not simple vibration, and the ultrasonic vibration also moves in the leftward-rightward direction. The purpose of adding the ultrasonic vibration in Patent Document 2 is to improve mechanical properties of a metal depending on the growth type thereof during welding. Patent Document 2, which is intended to improve the thermal effect of the metal that is welded and the metal structure thereof while welding is performed without problems, does not seem to recognize the problem of the focal position. Patent Document 2 directly affects the metal welded using ultrasonic energy, by which, however, the deviation of the focal point is not addressed.

Patent Document 3 discloses technology to create a magnetic field around a laser welding unit in order to vibrate a material. Patent Document 3, which is intended to exhaust gas which may be generated during welding, is only applicable to a magnetic material where the material that is welded needs to be vibrated by a magnetic field, and is applied to an already molten metal regardless of welding focus. In Patent Document 3, the spacing of the material is changed upwards and downwards, which may exacerbate the focus deviation problem of the present invention.

As such, no clear solution to reduce or inhibit weak welds caused by laser welding between thin metals while utilizing a conventional PCB without change has been proposed.
Korean Patent Application Publication No. 2016-0104931 ("Patent Document 1")
Japanese Patent Application Publication No. 2010-086899 ("Patent Document 2")
Korean Registered Patent Publication No. 0612905 ("Patent Document 3")

### [Disclosure]

### [Technical Problem]

It is an object of the present invention to provide a laser welding apparatus capable of reducing or inhibiting weak welds which may occur due to focal position deviation during laser welding between metals each having a small thickness and a welding method using the same.

### [Technical Solution]

In order to accomplish the above object, the present invention provides a laser welding apparatus including a lower jig, a laser welding unit configured to weld a metal and another metal to each other, the metal being disposed at an upper surface of a PCB disposed on the lower jig, and an upper jig configured to support at least one of at least a part of the upper surface of the PCB, at least a part of an upper surface of the metal, and at least a part of an upper surface of the another metal, wherein:
the upper jig is fixed such that the vertical position of the upper jig is constant, or when the upper jig is moved upwards and downwards, the upper jig is configured to be fixed at a specific position.

At this time, the lower jig may be moved upwards and downwards by a moving unit.

The upper jig may support the at least a part of the upper surface of the another metal, and may further support at least one of the upper surface of the PCB and the upper surface of the metal.

The lower jig may be moved by the moving unit to a position at which the lower jig is fixed by the upper jig. That is, the position of the lower jig fixed by the upper jig may be constant, and when the metal and the another metal to be welded are fixed at a constant height of the upper jig using the lower jig, the distance to the laser welding unit may be set to be constant in consideration of the thickness of the another metal and the thickness of the metal measured in advance. As a result, the focus of the laser welding unit may also be formed consistently.

The upper jig may be pressed by the moving unit, but the position of the upper jig is first fixed, whereby at least one of the at least a part of the upper surface of the PCB, the at least a part of the upper surface of the metal, and the at least a part of the upper surface of the another metal abutting the upper jig may have a constant height. It is preferable for the position of the upper surface of the another metal, at which actual welding is performed, to be constant. The moving unit may be provided with an elastic member or a buffer member such that the PCB, the metal, and the another metal are not damaged when subjected to a certain degree of pressure. As a non-limiting example, the elastic member or the buffer member may be a spring.

The upper jig may be provided with a protrusion to simultaneously support the another metal and the metal and additionally the PCB.

A support unit configured to support the upper jig may be provided at the side of the PCB. The separate support unit may be fixed to fix the upper jig at a constant position, and the downward position of the upper jig may be fixed by the support unit.

In addition, the present invention provides a laser welding apparatus including a lower jig and a laser welding unit configured to weld a metal and another metal to each other, the metal being disposed at an upper surface of a PCB disposed on the lower jig, wherein:
the laser welding apparatus includes a vibrating portion configured to vibrate the PCB upwards and downwards. At this time, an upper jig is not absolutely necessary, and only the lower jig may be provided.

The lower jig supports at least one surface of a lower part of the PCB, and the metal is formed at one surface of an upper part of the PCB.

The laser welding unit of the laser welding apparatus according to the present invention may be moved horizontally, but the vertical position thereof is fixed and constant.

The vibrating portion may vibrate the lower jig upwards and downwards, and when the lower jig and the upper jig are simultaneously vibrated upwards and downwards, the vibrating portion may be disposed at any position of the lower jig or the upper jig.

The laser welding apparatus may further include an upper jig configured to support at least one of at least a part of the upper surface of the PCB, at least a part of an upper surface of the metal, and at least a part of an upper surface of the another metal, and the upper jig may be vibrated upwards and downwards with the lower jig.

In another case, the laser welding apparatus may further include an upper jig configured to support at least one of at least a part of the upper surface of the PCB, at least a part of the upper surface of the metal, and at least a part of the upper surface of the another metal, the upper jig may include at least one of an elastic member and a buffer member, and the upper jig may be moved separately from the lower jig.

Unlike the two cases, the vertical position of the upper jig may be fixed, in which case a part of the PCB may be slightly vibrated due to vibration of the lower jig.

The metal may be mounted on the PCB, and the metal may have a thickness of 0.05 mm to 0.2 mm. In addition, the metal may need not protrude from the surface of the PCB.

In addition, the present invention provides a welding method using the laser welding apparatus, the welding method including:
1) disposing the PCB having the metal disposed at the upper surface thereof on the lower jig;
2) fixing the at least one of the at least the part of the upper surface of the PCB, the at least the part of the upper surface of the metal, and the at least the part of the upper surface of the another metal to the upper jig; and
3) welding the metal and the another metal to each other using a laser.

Fixing in step 2) may be performed by moving the lower jig upwards and downwards.

In addition, the present invention provides a welding method using the laser welding apparatus, the welding method including:
1) disposing the PCB having the metal disposed at the upper surface thereof on the lower jig;
2) vibrating the PCB upwards and downwards; and
3) welding the metal and the another metal to each other using a laser. At this time, welding may be performed using only the lower jig without an upper jig.

Step 3) may be performed earlier than step 2), or step 2) and step 3) may be simultaneously performed. Step 1-1) fixing the at least one of the at least a part of the upper surface of the PCB, the at least a part of the upper surface of the metal, and the at least a part of the upper surface of the another metal to the upper jig may be added after step 1). At this time, the upper jig and the lower jig may be simultaneously vibrated, or the upper jig may include at least one of an elastic member and a buffer member, and the upper jig and the lower jig may be moved separately from each other.

In the present invention, laser welding may be performed such that trajectories of a laser do not overlap.

In addition, the present invention provides an electrical device welded using the laser welding apparatus.

The present invention may provide any combinations of the above solving means.

### [Advantageous Effects]

As is apparent from the above description, the prevent invention provides a laser welding apparatus capable of fixing an upper jig at a constant position to fix the focus of a laser welding unit at a constant height, thereby reducing or inhibiting weak welds which may occur due to focal position deviation during laser welding between metals each having a small thickness, and a welding method using the same.

In addition, the prevent invention provides a laser welding apparatus capable of intermittently hitting the focus of a laser welding unit through vibration, thereby reducing or inhibiting weak welds, and a welding method using the same.

In the laser welding apparatus according to the present invention, welding is performed with omission of a metal pad that is conventionally used, whereby it is possible to reduce the manufacturing cost and reduce the thickness.

Particularly, the present invention has a feature of reducing or inhibiting weak welds when two metals each having a thickness of 0.1 mm or less are welded.

### [Description of Drawings]

FIG. 1 is a sectional schematic view of a conventional laser welding apparatus 10.
FIG. 2 is a sectional schematic view of another conventional laser welding apparatus 20.
FIG. 3 shows examples of a pattern resulting from laser welding.
FIG. 4 is a sectional schematic view showing a laser welding apparatus according to a first embodiment of the present invention.
FIG. 5 is a sectional schematic view showing a laser welding apparatus according to a second embodiment of the present invention.
FIG. 6 is a series of sectional views showing a welding method using the laser welding apparatus according to the second embodiment of the present invention, arranged in order.
FIG. 7 is a sectional schematic view showing a laser welding apparatus according to a third embodiment of the present invention.
FIG. 8 is a sectional schematic view showing a laser welding apparatus according to a fourth embodiment of the present invention.
FIG. 9 is a sectional schematic view showing a laser welding apparatus according to a fifth embodiment of the present invention.

### [Best Mode]

Now, preferred embodiments of the present invention will be described in detail with reference to the accompanying drawings such that the preferred embodiments of the present invention can be easily implemented by a person having ordinary skill in the art to which the present invention pertains. In describing the principle of operation of the preferred embodiments of the present invention in detail, however, a detailed description of known functions and configurations incorporated herein will be omitted when the same may obscure the subject matter of the present invention.

In addition, the same reference numbers will be used throughout the drawings to refer to parts that perform similar functions or operations. In the case in which one part is said to be connected to another part throughout the specification, not only may the one part be directly connected to the other part, but also, the one part may be indirectly connected to the other part via a further part. In addition, that a certain element is included does not mean that other elements are excluded, but means that such elements may be further included unless mentioned otherwise.

Hereinafter, a laser welding apparatus according to the present invention will be described with reference to the accompanying drawings.

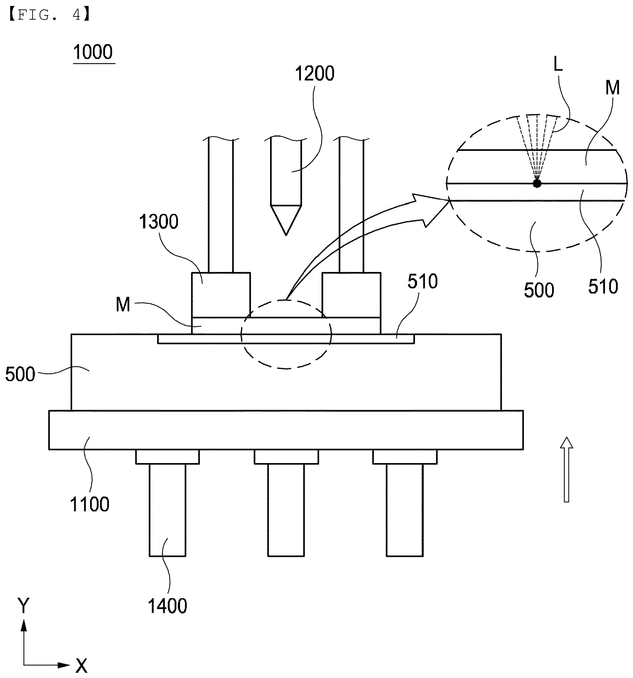

FIG. 4 is a sectional schematic view showing a laser welding apparatus according to a first embodiment of the present invention.

Referring to FIG. 4, the laser welding apparatus 1000 according to the first embodiment of the present invention includes a lower jig 1100, a laser welding unit 1200, an upper jig 1300, and a moving unit 1400.

The lower jig 1100, which supports a printed circuit board (PCB) 500, may be formed in the form of a plate and may be made of, for example, a metal material, but is not limited thereto as long as the lower jig is capable of supporting the PCB 500 and is not damaged by certain pressing force.

Here, the PCB 500 may be a board made of an electrically insulating material, and a metal 510 made of a conductive material may be mounted in an upper surface of the PCB 500.

At this time, the metal 510 may be copper foil, and may have a thickness of 0.05 mm to 0.1 mm.

Another metal M may be an electrode lead having one side connected to an electrode tab protruding from an electrode assembly, and may have a thickness of 0.1 mm to 0.15 mm.

Each of the metal 510 and the another metal M may be made of any one selected from among copper, aluminum, tin, zinc, iron, gold, and silver or an alloy thereof.

A general laser welding machine used to weld a thin metal is used as the laser welding unit 1200, and therefore a detailed configuration thereof and a detailed description thereof will be omitted.

Briefly, the laser welding unit 1200, which is used to weld the metal 510 and the another metal M to each other, may include a laser welding body (not shown), a laser welding head (not shown) provided under the laser welding body, and a moving portion (not shown) configured to move the laser welding head in a horizontal direction.

The laser welding head is provided with a laser beam radiation portion (not shown) configured to radiate a laser beam such that laser welding between the metals can be performed.

In addition, an exhaust unit (not shown) configured to suction air or the like may be provided in the vicinity of the laser welding head in order to remove metal fumes that may be generated during laser welding between the metals.

The upper jig 1300 may press a part of an upper surface of the another metal M that is located on the metal 510, specifically a part of an edge of the upper surface of the another metal, in order to fix the metal 510 and the another metal M to each other in tight contact with each other.

The upper jig 1300 may be hydraulic, but is not limited thereto as long as it is possible to press the upper surface of the another metal M in order to fix the metal 510 and the another metal M to each other in tight contact with each other.

Although the upper jig 1300 is shown as pressing the upper surface of the another metal M in the figure, the upper jig may also press a part of the PCB 500 or the metal 510 in order to fix the same, as needed.

The moving unit 1400 may be located under the lower jig 1100 to support the lower jig 1100, and may move upwards to press a lower surface of the lower jig 1100.

The lower jig 1100 may be moved upwards by the pressure of the moving unit 1400 so as to be fixed to the upper jig 1300, which is fixed at a constant position. There is an advantage in that the metal 510 of the PCB 500 is moved upwards by the moving unit 1400 to reduce the thickness deviation of the metal 510 mounted in the PCB 500, whereby it is possible to prevent the occurrence of weak welds due to the thickness deviation of the metal 510 during welding using a laser L. The tolerance of the another metal M is not greater than the tolerance of the PCB or the laser welding unit, and therefore when the another metal M is brought into tight contact with the upper jig 1300, the part at which the another metal M and the metal 510 are in contact has a constant height.

The moving unit 1400 may be configured to have a structure in which the moving unit further moves upwards to press the lower surface of the lower jig 1100 even after the PCB 500 and the metal 510 are supported by the lower jig 1100 and the upper jig 1300.

However, the moving unit 1400 is not limited thereto in structure as long as, as an example, the moving unit is configured to have a hydraulic structure capable of pressing and upwardly moving the lower jig 1100 and upwardly moving the lower jig 1100 to reduce the thickness deviation of the PCB 500 during welding.

Meanwhile, in the first embodiment, the position of the upper jig 1300 is fixed, and in a modification thereof, the laser welding unit 1200 may be vibrated up and down in order to reduce weak welds with additional tolerance.

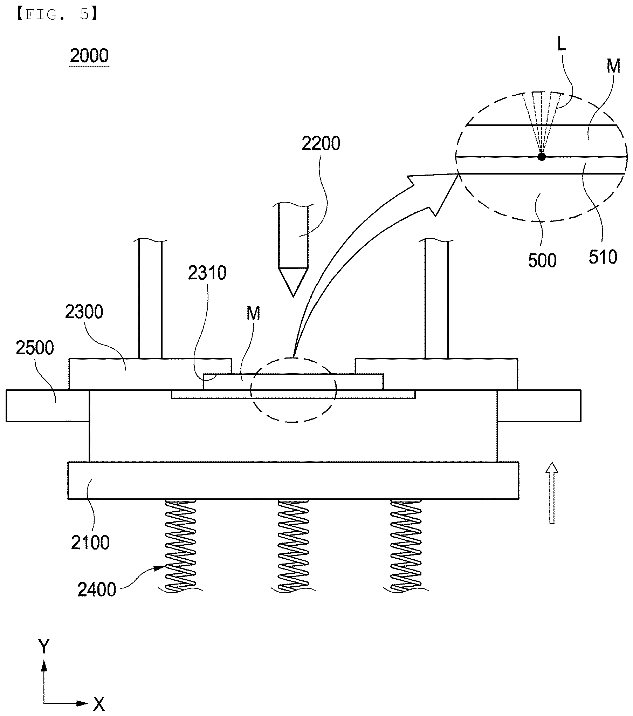

FIG. 5 is a sectional schematic view showing a laser welding apparatus 2000 according to a second embodiment of the present invention.

Referring to FIG. 5, the laser welding apparatus 2000 according to the second embodiment of the present invention is identical to the laser welding apparatus 1000 according to the first embodiment described with reference to FIG. 4 except for the shape of an upper jig 2300, a moving unit 2400, and the addition of a support unit 2500, and therefore a description of the same configuration will be omitted.

The laser welding apparatus 2000 according to the second embodiment of the present invention includes a lower jig 2100 configured to support a PCB 500, a laser welding unit 2200 configured to weld a metal 510 of the PCB 500 and another metal M to each other, an upper jig 2300 configured to press a part of the another metal M and a part of an upper surface of the PCB 500, a moving unit 2400 configured to press a lower surface of the lower jig 2100, and a support unit 2500 located at the side of the PCB 500.

The upper jig 2300 according to the second embodiment may be provided with a protrusion 2310 formed at the same height as the another metal M, whereby it is possible to simultaneously fix the another metal M and the PCB 500, and therefore it is possible to more stably maintain the positions thereof.

The moving unit 2400 according to the second embodiment may be a resilient elastic body, which has the advantage of relieving excessive pressure applied to the PCB 500 when the moving unit 2400 moves upwards to press the lower jig 2100, thereby preventing damage to the PCB 500.

The moving unit 2400 may be, for example, a spring, but is not limited thereto as long as the moving unit is configured to have a structure capable of relieving excessive pressure applied to the PCB 500 as the result of upward movement of the moving unit 2400.

The support unit 2500 is located at each side of PCB 500 to support an edge of a lower surface of the upper jig 2300 when the upper jig 2300 is moved downwards.

The support unit 2500 has the advantage of supporting the edge of the lower surface of the upper jig 2300 when the upper jig is moved downwards, as described above, thereby preventing the PCB 500 or the another metal M from being damaged by pressure as the result of downward movement of the upper jig 2300 more than necessary. In addition, the position of the support unit 2500 may be fixed, whereby it is possible to fix a downward movement position of the upper jig 2300.

The support unit 2500 has the advantage of ensuring that the position to which the upper jig 2300 is moved downwards for pressing remains constant, and may be adjustable in height depending on conditions such as the thickness of the PCB 500.

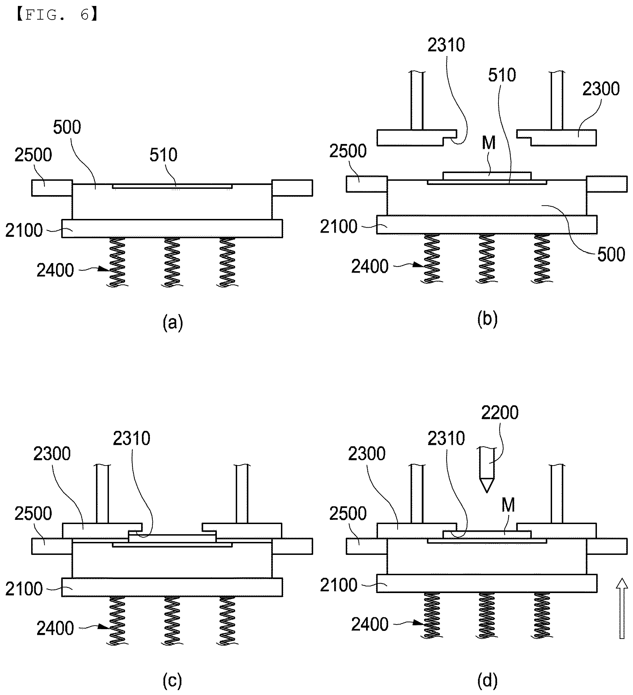

FIG. 6 is a series of sectional views showing a welding method using the laser welding apparatus 2000 according to the second embodiment of the present invention, arranged in order.

Referring to FIG. 6, the welding method using the laser welding apparatus according to the present invention includes 1) a step of locating a PCB 500 on an upper surface of the lower jig 2100, 2) a step of fixing a metal 510 of the PCB 500 and another metal M to each other using the upper jig 2300, 3) a step of pressing a lower surface of the lower jig 2100 through the moving unit 2400, and 4) a step of welding the metal 510 and the another metal M to each other.

The step of locating the PCB 500 on the upper surface of the lower jig 2100 is a step of locating the PCB 500 on the upper surface of the lower jig 2100 and locating another metal M on an upper surface of a metal 510 of the PCB 500.

The step of fixing the metal 510 of the PCB 500 and the another metal M to each other using the upper jig 2300 is a step of moving the upper jig 2300 downwards to press an upper surface of at least one of the PCB 500 located on the upper surface of the lower jig 2100 and the another metal M in order to fix the same.

At this time, a support unit 2500 may be provided at the side of the PCB 500, and the support unit 2500 may prevent the PCB 500 from being damaged due to downward movement of the upper jig 2300 more than necessary.

The step of pressing the lower surface of the lower jig 2100 through the moving unit 2400 is a step of pressing the lower surface of the lower jig 2100 using the moving unit 2400 to move the lower jig upwards, thereby moving the PCB seated on the lower jig 2100 upwards.

At this time, the thickness deviation may be reduced as the result of upward movement of the PCB 500, whereby it is possible to prevent the occurrence of weak welds. The support unit 2500 has the advantage of ensuring that the position to which the upper jig 2300 is moved downwards for pressing remains constant, and may be adjustable in height depending on conditions such as the thickness of the PCB 500.

The step of welding the metal 510 and the another metal M to each other is a step of welding the metal 510 and the another metal M, fixed by the lower jig 2100 and the upper jig 2300, to each other.

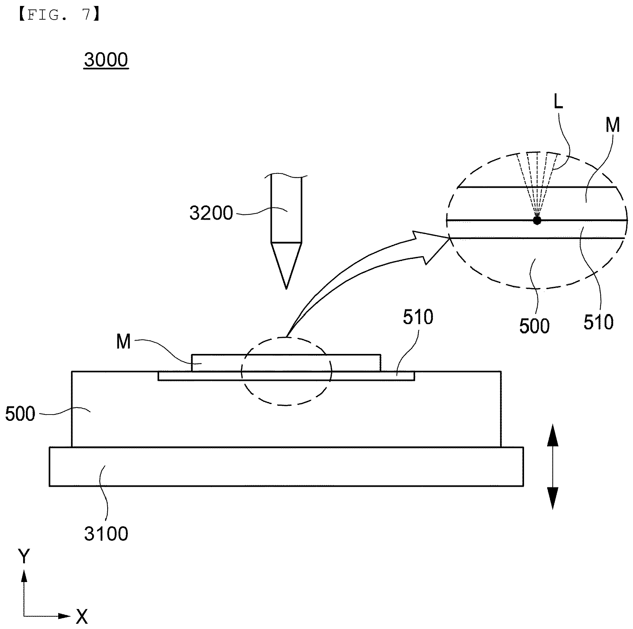

FIG. 7 is a sectional schematic view showing a laser welding apparatus 3000 according to a third embodiment of the present invention.

Referring to FIG. 7, the laser welding apparatus 3000 according to the third embodiment of the present invention includes a lower jig 3100 and a laser welding unit 3200.

The lower jig 3100, which supports a printed circuit board (PCB) 500, may be formed in the form of a plate and may be made of, for example, a metal material, but is not limited thereto as long as the lower jig is capable of supporting the PCB 500 and is not damaged by certain pressing force.

The lower jig 3100 may have a built-in vibrating portion (not shown), or the vibrating portion may be separately added thereto. The lower jig 3100 may be vibrated in a vertical direction by the vibrating portion.

The vibrating portion may repeatedly apply vibration to the lower jig 3100 with an amplitude of ±0.2 mm, and may vibrate in the vertical direction, whereby welding may be performed at an accurate position due to vibration when the metal 510 of the PCB 500 and the another metal M are welded to each other using the laser welding unit 3200, and therefore it is possible to reduce the occurrence of weak welds.

Here, the PCB 500 may be a board made of an electrically insulating material, and a metal 510 made of a conductive material may be mounted in an upper surface of the PCB 500.

At this time, the metal 510 may be copper foil, and may have a thickness of 0.05 mm to 0.1 mm.

The another metal M may be an electrode lead having one side connected to an electrode tab protruding from an electrode assembly, and may have a thickness of 0.1 mm to 0.15 mm.

Each of the metal 510 and the another metal M may be made of any one selected from among copper, aluminum, tin, zinc, iron, gold, and silver or an alloy thereof.

A general laser welding machine used to weld a thin metal is used as the laser welding unit 3200, and therefore a detailed configuration thereof and a detailed description thereof will be omitted.

Briefly, the laser welding unit 3200, which is used to weld the metal 510 and the another metal M to each other, may include a laser welding body (not shown), a laser welding head (not shown) provided under the laser welding body, and a moving portion (not shown) configured to move the laser welding head in a horizontal direction.

The laser welding head is provided with a laser beam radiation portion (not shown) configured to radiate a laser beam such that laser welding between the metals can be performed.

In addition, an exhaust unit (not shown) configured to suction air or the like may be provided in the vicinity of the laser welding head in order to remove metal fumes that may be generated during laser welding between the metals.

As described above, the laser welding unit 3200 may perform welding at an accurate position in the state in which the metal 510 and the another metal M are vibrated in an upward-downward direction by the vibrating portion of the lower jig 3100. In FIG. 7, when the metal 510 and the another metal M are vibrated in the upward-downward direction by the vibrating portion while the laser welding unit 3200 is moved by the moving portion in a horizontal direction (x direction) at the same height (y direction), the case in which the laser is focused on the contact part of the metal 510 and the another metal M periodically occurs, and at this time the metal 510 and the another metal M are welded to each other. When viewed in section thereof, a welded region may be formed in the shape of a dotted line. Spacing of welded dotted lines is adjusted according to the movement speed of the moving portion or the vibration period of the vibrating portion.

Preferably, the trajectory of the laser welding unit for welding is (b) to (f) in FIG. 3. In the case of the first and second embodiments, there is no vibration, and therefore a welded part may be formed in the shape of a solid line. In third to fifth embodiments, however, vibration is added, and therefore a welded part may be formed in the shape of a dotted line rather than a solid line. In the case of (a) of FIG. 3, the overlapping part may be overwelded, and therefore a non-overlapping trajectory is preferable. (b) to (f) of FIG. 3 are examples of the non-overlapping trajectory, which may be modified in various forms as long as the trajectory does not overlap.

A device configured to change rotational motion of a motor into vibration motion may be used as the vibration portion, and rotational motion may be changed into vibration motion using a rotating portion that does not coincide with the rotational axis of the motor. In addition, there are various other devices capable of generating vibration, which may be selected as needed by a person of ordinary skill in the art.

The vibration portion according to the present invention preferably has a frequency of 1 Hz to 10000 Hz, more preferably 10 Hz to 1000 Hz, most preferably 50 Hz to 500 Hz.

The vibration portion according to the present invention preferably has an amplitude of 0.1 mm to 5 mm, more preferably 0.2 mm to 3 mm, most preferably 0.3 mm.

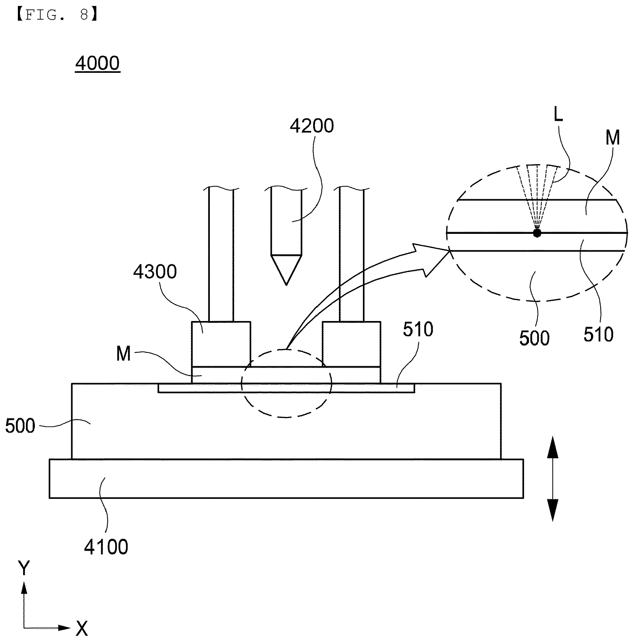

FIG. 8 is a sectional schematic view showing a laser welding apparatus 4000 according to a fourth embodiment of the present invention.

Referring to FIG. 8, the laser welding apparatus 4000 according to the fourth embodiment of the present invention is identical to the laser welding apparatus 3000 according to the third embodiment described with reference to FIG. 7 except that an upper jig 4300 is further provided, and therefore a description of the same configuration will be omitted.

The laser welding apparatus 4000 according to the fourth embodiment of the present invention includes a lower jig 4100 configured to support a PCB 500, a laser welding unit 4200 configured to weld a metal 510 of the PCB 500 and another metal M to each other, and an upper jig 4300 configured to press a part of an upper surface of the another metal M.

As described above, the upper jig 4300 has the advantage of pressing an edge of the upper surface of the another metal M to fix the metal 510 and the another metal M in tight contact with each other, thereby improving weld quality.

At this time, the upper jig 4300 may be moved with the lower jig 4100 according to upward and downward movement of the lower jig 4100 caused by the vibrating portion.

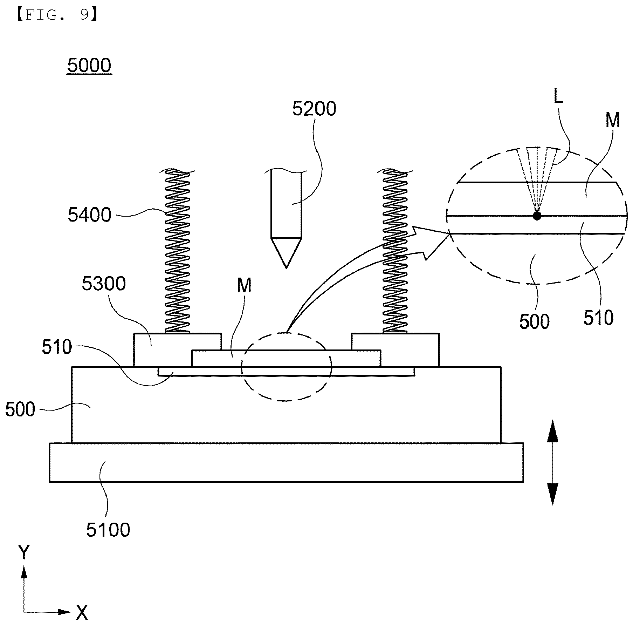

FIG. 9 is a sectional schematic view showing a laser welding apparatus 5000 according to a fifth embodiment of the present invention.

Referring to FIG. 9, the laser welding apparatus 5000 according to the fifth embodiment of the present invention is identical to the laser welding apparatus 3000 according to the third embodiment described with reference to FIG. 7 except that an upper jig 5300 and an elastic member 5400 are further provided, and therefore a description of the same configuration will be omitted.

The laser welding apparatus 5000 according to the fifth embodiment of the present invention includes a lower jig 5100 configured to support a PCB 500, a laser welding unit 5200 configured to weld a metal 510 of the PCB 500 and another metal M to each other, and an upper jig 5300 and an elastic member 5400 configured to press a part of an upper surface of the another metal M and a part of an upper surface of the PCB 500.

The upper jig 5300 according to the fifth embodiment may be provided with a protrusion formed at the same height as the another metal M, whereby it is possible to simultaneously fix the another metal M and the PCB 500, and therefore it is possible to more stably maintain the positions thereof. The upper jig 5300 may not be moved with the lower jig 5100.

In addition, the elastic member 5400, which is flexible, is provided on the upper jig 5300, whereby it is possible to prevent damage to the PCB 500 and the another metal M by excessive pressure when the upper jig 5300 presses the PCB and the another metal. A separate moving means for pressing, such as a piston, may be added to the upper jig 5300.

The elastic member 5400 may be, for example, a spring, but is not limited thereto as long as the elastic member is capable of relieving excessive pressure applied to the another metal M and the PCB 500

A welding method using the laser welding apparatus according to each of the third to fifth embodiments includes a step of locating a PCB 500 on an upper surface of the lower jig 3100, 4100, or 5100, a step of vibrating the PCB 500 through the vibrating portion, and a step of welding a metal 510 and another metal M to each other.

The step of locating the PCB 500 on the upper surface of the lower jig 3100, 4100, or 5100 is a step of locating the PCB 500 on the upper surface of the lower jig 3100, 4100, or 5100 and locating another metal M on an upper surface of a metal 510 of the PCB 500.

The step of vibrating the PCB 500 through the vibrating portion is a step of operating the vibrating portion built in or attached to the lower jig 3100, 4100, or 5100 such that the metal 510 of the PCB 500 and the another metal M are in focus for welding.

The step of welding the metal 510 and the another metal M to each other is a step in which welding occurs at the moment when the metal 510 of the PCB 500 and the another metal M vibrated by the vibrating portion coincide with the focus of a laser L. This step may be performed earlier than the step of vibrating the PCB 500 through the vibrating portion, which is the previous step, or may occur simultaneously therewith.

In addition, when the laser welding apparatus 4000 according to the fourth embodiment is used, a step of pressing and supporting an upper surface of the another metal M using the upper jig 4300 may be further included before the step of welding the metal 510 and the another metal M to each other.

In addition, when the laser welding apparatus 5000 according to the fifth embodiment is used, a step of pressurizing and supporting an upper surface of the metal 510 of the PCB 500 and an upper surface of the another metal M using the upper jig 5300 may be further included before the step of welding the metal 510 and the another metal M to each other.

In addition, the present invention may provide an electrical device welded using the laser welding apparatus. The electrical device refers to an electrode assembly, a battery cell, a battery module, a battery pack, or a device including at least one thereof.

Although the specific details of the present invention have been described in detail, those skilled in the art will appreciate that the detailed description thereof discloses only preferred embodiments of the present invention and thus does not limit the scope of the present invention. Accordingly, those skilled in the art will appreciate that various changes and modifications are possible, without departing from the category and the technical idea of the present invention, and it will be obvious that such changes and modifications fall within the scope of the appended claims.

### (Description of Reference Symbols)

10, 20, 1000, 2000, 3000, 4000, 5000: Laser welding apparatuses
100, 1100, 2100, 3100, 4100, 5100: Lower jigs
200, 1200, 2200, 3200, 4200, 5200: Laser welding units
300, 1300, 2300, 4300, 5300: Upper jigs
2310: Protrusion
1400, 2400: Moving units
5400: Elastic member
2500: Support unit
500, 600: PCBs
510, 610: Metals
M: Another metal
L: Laser
P: Metal pad

## Claims

1. A laser welding apparatus comprising:
a lower jig;
a laser welding unit configured to weld a metal and another metal to each other, the metal being disposed at an upper surface of a PCB disposed on the lower jig; and
an upper jig configured to support at least one of at least a part of the upper surface of the PCB, at least a part of an upper surface of the metal, and at least a part of an upper surface of the another metal, wherein:
the upper jig is fixed such that a vertical position of the upper jig is constant, or
when the upper jig is moved upwards and downwards, the upper jig is configured to be fixed at a specific position.

2. The laser welding apparatus according to claim 1, wherein the lower jig is moved by a moving unit to a position at which the lower jig is fixed by the upper jig.

3. The laser welding apparatus according to claim 1, wherein a support unit configured to support the upper jig is provided at a side of the PCB.

4. A laser welding apparatus comprising:
a lower jig; and
a laser welding unit configured to weld a metal and another metal to each other, the metal being disposed at an upper surface of a PCB disposed on the lower jig, wherein
the laser welding apparatus comprises a vibrating portion configured to vibrate the PCB upwards and downwards.

5. The laser welding apparatus according to claim 4, wherein the vibrating portion vibrates the lower jig upwards and downwards.

6. The laser welding apparatus according to claim 4, further comprising an upper jig configured to support at least one of at least a part of the upper surface of the PCB, at least a part of an upper surface of the metal, and at least a part of an upper surface of the another metal,
wherein the upper jig is vibrated upwards and downwards with the lower jig.

7. The laser welding apparatus according to claim 4, further comprising an upper jig configured to support at least one of at least a part of the upper surface of the PCB, at least a part of an upper surface of the metal, and at least a part of an upper surface of the another metal,
wherein the upper jig comprises at least one of an elastic member and a buffer member, and
wherein the upper jig is moved separately from the lower jig.

8. The laser welding apparatus according to any one of claims 1 to 7, wherein
the metal is mounted on the PCB, and
the metal has a thickness of 0.05 mm to 0.2 mm.

9. A welding method using the laser welding apparatus according to any one of claims 1 to 3, the welding method comprising:
1) disposing the PCB having the metal disposed at the upper surface thereof on the lower jig;
2) fixing the at least one of the at least the part of the upper surface of the PCB, the at least the part of the upper surface of the metal, and the at least the part of the upper surface of the another metal to the upper jig; and
3) welding the metal and the another metal to each other using a laser.

10. The welding method according to claim 9, wherein the fixing in step 2) is performed by moving the lower jig upwards and downwards.

11. A welding method using the laser welding apparatus according to any one of claims 4 to 7, the welding method comprising:
1) disposing the PCB having the metal disposed at the upper surface thereof on the lower jig;
2) vibrating the PCB upwards and downwards; and
3) welding the metal and the another metal to each other using a laser.

12. The welding method according to claim 11, wherein
step 3) is performed earlier than step 2), or
step 2) and step 3) are simultaneously performed.

13. The welding method according to claim 11, wherein 1-1) fixing the at least one of the at least a part of the upper surface of the PCB, the at least a part of the upper surface of the metal, and the at least a part of the upper surface of the another metal to the upper jig is added after step 1).

14. An electrical device welded using the laser welding apparatus according to any one of claims 1 to 7.
